# EUROPEAN PATENT APPLICATION

(11) **EP 4 242 809 A1**
(43) Date of publication of application: **13.09.2023**
(21) Application number: 20935198.0
(22) Date of filing: 09.12.2020
(51) Int. Cl.: G06F 3/0481

(54) **THREE-DIMENSIONAL SIMULATION DISPLAY SYSTEM FOR NUCLEAR POWER PLANT**

(30) Priority: 15.10.2020 CN 202011100539
(71) Applicant: China Nuclear Power Engineering Co., Ltd., Shenzhen, Guangdong 518124 (CN); China General Nuclear Power Corporation, Shenzhen, Guangdong 518026 (CN); CGN Power Co., Ltd., Shenzhen, Guangdong 518026 (CN)
(72) Inventor: ZHANG, Zhen Nan, Shenzhen, Guangdong 518124 (CN); WEI, Shu Hong, Shenzhen, Guangdong 518124 (CN); LIANG, Wei Lun, Shenzhen, Guangdong 518124 (CN)
(74) Representative: Greaves Brewster LLP
(86) International application number: PCT/CN2020/134728
(87) International publication number: WO 2021/227469

(57) **Abstract**

The present invention provides a three-dimensional simulation display system for a nuclear power plant including a pre-editing module (100), an interaction module (200), a simulation module (300) and a display module (400), wherein the pre-editing module (100) is used for setting initialization information, the interaction module (200) is used for recording an operation instruction issued by a user and sending the operation instruction to the simulation module (300) for processing, and the simulation module (300) is used for calling target initialization information from the pre-editing module (100) according to the operation instruction, integrating the target initialization information and generating a corresponding feedback result, and sending the feedback result to the display module (400) and presenting the same to the user. The three-dimensional simulation display system for a nuclear power plant has a three-dimensional model covering the plant area distribution of the whole plant and the systems, structures and device in the plant buildings, and an information presentation capability. The three-dimensional simulation display system for a nuclear power plant can be used for on-site safety training of power plant staff, training regarding the processes of primary and secondary systems of a nuclear power plant, device training, human flow and material flow path planning during an overhaul and decommissioning, and on-site emergency drills. In addition, a solution is provided for common people to observe a nuclear power plant at close range, to know the working principle of the power plant and eliminate the fear of nuclear power.

## Description

### FIELD OF THE INVENTION

The present invention generally relates to the simulation field of nuclear power plant and, more particularly, relates to a three-dimensional simulation display system for a nuclear power plant.

### BACKGROUND OF THE INVENTION

With the rapid development of three-dimensional simulation technology, various kinds of three-dimensional building models and information display systems are widely used in the fields of park management, engineering construction, exhibition promotion and real estate sales due to immediacy, convenience and strong interaction. Some nuclear power plants have also taken the opportunity to develop plant tour/display systems, thereby breaking through the previous flat display means, and improving the user experience with the help of the three-dimensional model and interactive features of the simulation system, so as to promote nuclear power to the public at close range. However, the conventional three-dimensional display system of nuclear power plants adopts the market general technology, and the only difference lies in that the power plant model replaces the ordinary building model. The interactive means, operational layout, system function settings still adopts the old means. Therefore, it is difficult to apply to the special circumstances of nuclear power plants.

However, the conventional three-dimensional simulation display system at least has the following disadvantages:
(1) The interaction means is not enough and it is only suitable for the three-dimensional buildings with simple structure, less internal arrangement and desirable appearance display;
(2) The users can only tour freely but cannot view the radiation zoning in different floor areas, which cannot meet the display demand for radiation zoning of nuclear power plant;
(3) The simple operation logic only meets the needs of the public science exhibition and lacks professional quick query channel for nuclear power technicians;
(4) The three-dimensional simulation display system has simple function and lacks training functions such as human flow and logistics planning and emergency drill, and cannot make full use of the advantages of the three-dimensional display system;
(5) The professional level of the three-dimensional simulation display system is low, the model of power plant is imprecise, and the operation and route planning of virtual characters in the system do not conform to the operation rules of power plant.
(6) The display information is insufficient and lacks detailed system, plant structure and device introduction.

### SUMMARY OF THE INVENTION

One object of the present invention is to provide a three-dimensional simulation display system for a nuclear power plant, to solve the technical problems mentioned above.

According to one embodiment of the present invention, a three-dimensional simulation display system for a nuclear power plant includes a pre-editing module, an interaction module, a simulation module and a display module,
wherein the pre-editing module is used for setting initialization information, the initialization information includes all models of the nuclear power plant, initial source item information of each model, and detailed information of the all plant device, system and plant structure;
the interaction module is used for recording an operation instruction issued by a user and sending the operation instruction to the simulation module for processing;
the simulation module is used for receiving the operation instruction, calling target initialization information from the pre-editing module according to the operation instruction, integrating the target initialization information and generating a corresponding feedback result, and sending the feedback result to the display module;
the display module is used for presenting the feedback result to the user in form of a specific layout graphical interface.

According to one embodiment of the present invention, the pre-editing module includes a model processing unit, the model processing unit is used for modifying a preset model online or importing a target model file in a preset format, and automatically associating a corresponding script file after replacing an original model file with a target model file.

According to one embodiment of the present invention, the interaction module includes a virtual sandboxie interacting unit and a radiation field interacting unit,
the virtual sandboxie interacting unit is used for sending a first operation instruction to the simulation module according to a real-time operation of a user, and the first operation instruction is used for calling a miniature sandboxie comprising all models, adjusting transparency of the models in the miniature sandboxie and an angle of horizontal rotation of the model around a central point, and automatically explaining, enlarging and reducing the miniature sandboxie; all models comprise a plant structure model of the nuclear power plant and a nuclear power device model;
the radiation field interacting unit is used for sending a second operation instruction to the simulation module according to the real-time operation of the user, the second operation instruction is used for calculating a three-dimensional radiation dose field of a target plant according to the initial source term information, and displaying the three-dimensional radiation field distribution cloud map in form of red-yellow-green gradient in the target plant.

According to one embodiment of the present invention, the simulation module includes a sandboxie instruction processing unit, the sandboxie instruction processing unit is used for calling virtual sandboxie corresponding to different types of nuclear power units, and driving the display module to display in a form of technology tree-like arrangement, in which the virtual sandboxie of different technical routes are arranged in parallel and the virtual sandboxie of the same technical route is arranged in a row from low to high.

According to one embodiment of the present invention, the interaction module also includes a scene roaming interacting unit, the scene roaming interacting unit is used for sending a third operation instruction to the simulation module according to a real-time operation of the user, and the third operation instruction is used for setting a roaming start, generating a roaming route according to the tour path roaming mode chosen by the user or the free roaming mode, and counting roaming information of the roaming route.

According to one embodiment of the present invention, the simulation module also includes a roaming instruction processing unit, the roaming instruction processing unit includes a roaming start acquiring unit, a tour path roaming route generating unit, a free roaming path generating unit and an adding unit,
the roaming start acquiring unit is used for acquiring a virtual human position placed by the user during the virtual sandboxie interaction, and using the virtual human position as the roaming starting point; or acquiring a code entered by the user in the virtual sandboxie search box, and using the corresponding location of the code as the starting point for roaming;
the tour path roaming route generating unit is used for automatically planning and generating a shortest route, a least radiation absorbed dose route, an emergency evacuation route, or the human flow logistics route according to roaming purpose of the user;
the free roaming path generating unit is used for automatically generating a free roaming route according to a moving path of the virtual person in the virtual sandboxie, and counting roaming information including a route distance, a walking time and/or an intake dose;
the adding unit is used for adding the free roaming route selected by the user as a new emergency evacuation route or a human flow logistics route.

According to one embodiment of the present invention, the interaction module also includes a plant information interacting unit, a device information interacting unit and/or a system information interacting unit,
the plant information interacting unit is used for sending a fourth operation instruction to the simulation module according to the real-time operation of the user, and the fourth operation instruction is used for positioning a target plant structure model and calling detailed information of the target plant structure model;
the device information interacting unit is used for sending a fifth operation instruction to the simulation module according to the real-time operation of the user, and the fifth operation instruction is used for positioning a target nuclear power device model and calling detailed information of the target nuclear power device model;
the system information interacting unit is used for sending a sixth operation instruction to the simulation module according to the real-time operation of the user, and the sixth operation instruction is used for positioning all models of the target system and calling detailed information of the target system.

According to one embodiment of the present invention, the simulation module also includes a plant instruction processing unit, the plant instruction processing unit includes a target plant positioning unit and a plant information calling unit,
the target plant positioning unit is used for highlighting a target plant structure model the user positioned in the virtual sandboxie and/or scene roaming, or obtaining the plant structure code entered by the user in the virtual sandboxie search box, and highlighting the target plant structure model corresponding to the plant structure code;
the plant information calling unit is used for calling the detailed information of the target plant structure model and generating links to the corresponding design drawings of the target plant structure model, the detailed information comprises at least one of a name of the plant structure, a name of the plant where located, floors, compartments, elevations, radiation areas and geometric dimensions, the design drawing comprises a template drawing, a reinforcement drawing and/or an anchor position drawing of the target plant structure.

According to one embodiment of the present invention, the simulation module also includes a device instruction processing unit, the device instruction processing unit includes a target nuclear power device positioning unit and a device information calling unit,
the target nuclear power device positioning unit is used for highlighting a target nuclear power device model which is positioned by the user in the virtual sandboxie, scene roaming and/or system information interaction; or obtaining a nuclear power device code entered by the user in the virtual sandboxie search box, and highlighting the target nuclear power device model corresponding to the nuclear power device code;
the device information calling unit is used for calling the detailed information of the target nuclear power device model and generating a link to the corresponding design drawing of the target nuclear power device model, the detailed information comprises one or more of device names and abbreviations, space positions, ownership systems, device parameters, radiation data, device levels, purchasing and manufacturing information, and supplier information, the design drawings comprises installation drawings, device parts drawings, positioning drawings and/or device specifications of the target nuclear power equipment.

According to one embodiment of the present invention, the simulation module also includes a system instruction processing unit, the system instruction processing unit includes a target system positioning unit and a system information calling unit,
the target system positioning unit is used for obtaining a system code entered by the user in the virtual sandboxie search box, and highlighting all models of the target system corresponding to the system code; or obtaining a target system the user positioned in device information interaction, and highlighting all models of the target system;
the system information calling unit is used for calling detailed information of the target system and generating links to corresponding design drawings of the target system, the detailed information comprises one or more of system names and abbreviations, process parameters, system device lists, and radiation intensities, the design drawings comprise a system design guidance manual and/or a system flow chart.

The three-dimensional simulation display system for a nuclear power plant of the present invention has the ability to cover the distribution of the plant (including nuclear island plant, steam turbine plant and BOP plant), the three-dimensional model and information presentation of the system, structure and device in each plant. The three-dimensional simulation display system for a nuclear power plant of the present invention not only meets the needs of the general public and professionals for different interaction means, but also allows users to view detailed information about plant structure, systems and device, thereby breaking through the barriers between the three-dimensional models and various parameters, drawings and documents, displaying the three-dimensional radiation field of the nuclear power plant intuitively and professionally. The three-dimensional simulation display system for a nuclear power plant of the present invention can be used for on-site safety training of power plant staff, training regarding the processes of primary and secondary systems of a nuclear power plant, device training, human flow and material flow path planning during an overhaul and decommissioning, and on-site emergency drills. In addition, a solution is provided for common people to observe a nuclear power plant at close range, to know the working principle of the power plant and eliminate the fear of nuclear power.

### BRIEF DESCRIPTION OF THE DRAWINGS

In order to explain the technical solution of the embodiments of the present invention clearly, a brief introduction to the drawings required in the embodiments will be described as following. It should be understood that the drawings show only some embodiments of the present invention and, therefore, should not be seen as a limitation to the scope of the present invention. To one ordinary skilled in the art, other relevant drawings can also be obtained without creative work on the basis of the drawings.
Fig. 1 is a block diagram of a three-dimensional simulation display system for a nuclear power plant according to one embodiment of the present invention;
Fig. 2 is a block diagram of an interaction module according to one embodiment of the present invention;
Fig. 3 is a block diagram of a roaming instruction processing unit according to one embodiment of the present invention;
Fig. 4 is a block diagram of a plant instruction processing unit according to one embodiment of the present invention;
Fig. 5 is a block diagram of a device instruction processing unit according to one embodiment of the present invention; and
Fig. 6 is a block diagram of a system instruction processing unit according to one embodiment of the present invention.

### DETAILED DESCRIPTION OF THE INVENTION

The technical solution of the embodiments of the present invention will be described clearly and completely in combination with the drawings. Obviously, the embodiments described are only a part of the embodiments of the present invention, not all embodiments. Therefore, the following detailed description of embodiments of the present invention provided in the attached drawings is not intended to limit the scope of the present invention, but merely represents selected embodiments of the present invention. Based on the embodiments of the present invention, other embodiments obtained by one ordinary skilled in the art without creative work also fall within the scope of the present invention.

It should be noted that, if there is no conflict, the features in the embodiment of the present invention can be combined with each other and the combination still fall within the scope of the present invention. In addition, although functional modules are divided in the device schematic view and the logical sequence is shown in the flowchart, in some cases, the functional modules can be divided differently from modules in the described device, or logical sequence in a flowchart to perform the steps shown or described. Furthermore, the terms 'first', 'second', 'third' and the like used in the present invention do not restrict the data and the execution order, it is only to distinguish the same or similar items whose functions and functions are basically the same.

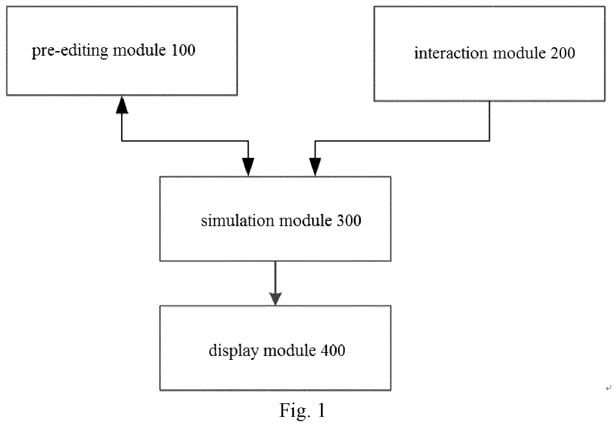

Referring to Fig. 1, a three-dimensional simulation display system for a nuclear power plant according to one embodiment of the present invention includes a pre-editing module 100, an interaction module 200, a simulation module 300 and a display module 400.

The pre-editing module 100 is used for setting initialization information, and the initialization information includes all models of the nuclear power plant, initial source item information of each model, and detailed information of the all plant device, system and plant structure.

The interaction module 200 is used for recording an operation instruction issued by a user and sending the operation instruction to the simulation module 300 for processing.

The simulation module 300 is used for receiving the operation instruction, calling target initialization information from the pre-editing module according to the operation instruction, integrating the target initialization information and generating a corresponding feedback result, and sending the feedback result to the display module.

The display module 400 is used for presenting the feedback result to the user in a specific layout graphical interface, thereby making the training of nuclear power plant site condition, structure system device training and information inquiry, human flow logistics planning, emergency evacuation drill more three-dimensional and intuitive, as well as improving the efficiency of training drill.

The three-dimensional simulation display system of a nuclear power plant according to one embodiment of the present invention will be described in detail as following.

Under normal circumstances, the system is provided with a standard nuclear power plant model, or provided with another nuclear power plant model having other type of reactor according to user requirements. However, in the construction, operation and decommissioning stages of power plants, the original design will be continuously upgraded, so that the actual situation of the power plant is different from that of the standard model. Therefore, the system allows users to modify the standard model. Specifically, the pre-editing module 100 includes a model processing unit for online modifying a preset model or importing a target model file in a preset format (such as. stp), and automatically associating a corresponding script file after replacing an original model file with a target model file.

The interaction module 200 is an integrated entrance of the functions at all levels of the system, and covers all operations that the user can perform through the system, such as nuclear power plant virtual sandboxie, scene roaming, plant structure view, device view, and system details view. The interaction module 200 collects the operation information of the user and generates the operation instruction. The simulation module 300 inside the system sends the required information or data to the user after computing.

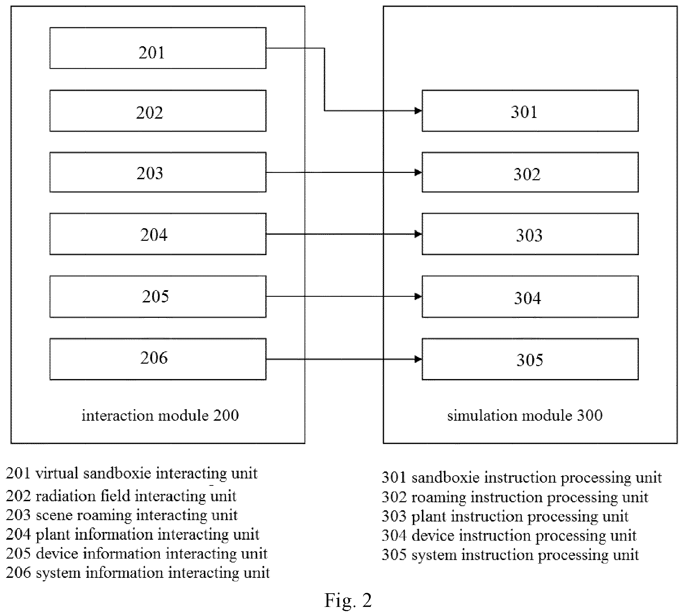

Referring to Fig. 2, according to one preferred embodiment of the present invention, the interaction module 200 includes a virtual sandboxie interacting unit 201. The virtual sandboxie interacting unit 201 is used for sending a first operation instruction to the simulation module 300 according to a real-time operation of a user, and the first operation instruction is used for calling a miniature sandboxie, adjusting transparency of the models in the miniature sandboxie and an angle of horizontal rotation of the model around a central point, and automatically explaining, enlarging and reducing the miniature sandboxie. Specifically, the virtual sandboxie of the nuclear power plant is placed in a virtual hall and is visible after the user logs in. It is a scaled-down sandboxie of the nuclear power plant, including all the models of the nuclear power plant, such as the building structure model of the nuclear power plant and nuclear power device model. The virtual sandboxie has the function of automatic explanation, which introduces the main plant area distribution and the system structure device of the nuclear power plant (this process can be skipped). Users can walk around the virtual sandboxie and observe the layout of the nuclear power plant from various perspectives. The users can also use external devices such as mouse/keyboard/touch screen to drag the nuclear power plant model around the center point and rotate horizontally, to realize the observation of the power plant from all angles. The miniature sandboxie can be enlarged and reduced, so that the user can understand the detailed layout of the global or local space of the nuclear power plant. At the same time, the models in the sandboxie, such as the outer wall of the plant and the containment vessel of the reactor building, can be selectively adjusted to be transparent to observe the internal structure of the nuclear power plant.

The design of the virtual sandboxie in the virtual hall allows users to interact with the plant model in a variety of ways. The plant structure, system and device can be searched by clicking on the selected device model, plant model, or by using the three-character code and coding principles commonly used in nuclear power, the former is WYSIWYG and suitable for civilian use, while the latter is faster, more accurate and professional and suitable for nuclear engineers and plant workers. The inner structure of the nuclear power plant is viewed from God's point of view, and becomes the entrance of scene roaming, plant structure model and detailed information viewing, device model and detailed information viewing.

At the same time, the virtual hall can set up several groups of virtual sandboxie corresponding to different nuclear power units. At this time, the simulation module 300 includes sandboxie instruction processing unit 301, the sandboxie instruction processing unit 301 is used for calling virtual sandboxie corresponding to different types of nuclear power units, and driving the display module 400 to display in a form of technology tree-like arrangement, in which the virtual sandboxie of different technical routes are arranged in parallel and the virtual sandboxie of the same technical route is arranged in a row. Therefore, when popularizing science, people can know the development route of nuclear power technology in our country, and directly compare the technical characteristics of different units.

Referring to Fig. 2, according to one embodiment of the present invention, the interaction module 200 also includes a radiation field interacting unit 202 for sending a second operation instruction to the simulation module 300 according to the real-time operation of the user. The second operation instruction is used for driving the simulation module 300 to calculate a three-dimensional radiation dose field of a target plant according to the initial source term information, and displaying the three-dimensional radiation field distribution cloud map in form of red-yellow-green gradient in the target plant.

Users can turn on or turn off the three-dimensional radiation field function in the two main display modes of virtual sandboxie and scene roaming. When the above function is turned on, the nuclear power plant building, the three-dimensional radiation field distribution cloud map of the reactor building gradually changes from red to green according to the radiation intensity. Red represents the high radiation intensity of the dangerous area, and green represents the low radiation intensity of the safe area.

Referring to Fig. 2, according to one embodiment of the present invention, the interaction module 200 also includes a scene roaming interacting unit 203 for sending a third operation instruction to the simulation module 300 according to a real-time operation of the user, and the third operation instruction is used for driving the simulation module 300 to set a roaming start, generate a roaming route according to the tour path roaming mode chosen by the user or the free roaming mode, and count roaming information of the roaming route.

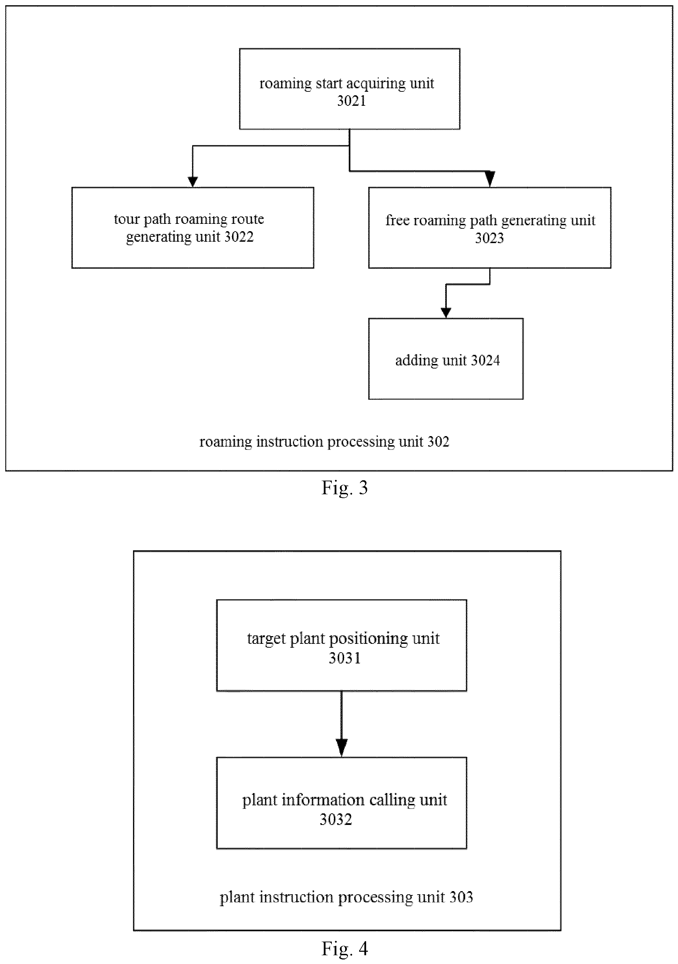

Specifically, referring to Fig. 3, the simulation module 300 includes a roaming instruction processing unit 302, the roaming instruction processing unit 302 includes a roaming start acquiring unit 3021, a tour path roaming route generating unit 3022, a free roaming path generating unit 3023 and an adding unit 3024.

The roaming start acquiring unit 3021 is used for acquiring the virtual person position placed by the user during the virtual sandboxie interaction, such as a corridor, a platform, a compartment, and a nearby device, and using the virtual human position as the starting point for roaming; or obtaining the code entered by the user in the virtual sandboxie search box, such as compartment, device, and system code. The interface then jumps to a specified location and uses the location of the code as the starting point for roaming according to the user's choice.

The tour path roaming route generating unit 3022 is used for automatically planning and generating a shortest route, a least radiation absorbed dose route, an emergency evacuation route, or the human flow logistics route according to roaming purpose of the user, for the use of the user, so that the user can conveniently know the various paths inside the nuclear power plant and deepen their understanding of the power plant.

The free roaming path generating unit 3023 is used for automatically generating a free roaming route according to a moving path of the virtual person in the virtual sandboxie. Under the free roaming mode, the users can plan route freely according to the visit, study and emergency needs. The free roaming path generating unit 3023 counts the route distance, the walking time and/or the intake dose. The user can drive the adding unit 3024 to add the new free roaming route as the new emergency evacuation route or the human flow and logistics route according to the statistical results, which can be used by the power plant to optimize the route. The function can be used for pre-job operation training of power plant staff, such as operation inspection patrol personnel, and training plant layout of new employees and other activities.

In the two roaming modes, the user can stay in the roaming process and select the target plant structure, device or system to obtain detailed information. That is, the scene roaming can be used as the entrance of the plant building structure model and the detailed information viewing, the device model and the detailed information viewing. For example, jump from the list of devices in the system to a certain device or from the introduction of the system where the device is located to the entire system can be realized. The process of information interaction is intuitive and clear, thereby solving the problems of complicated information and non-intuitionistic form caused by the inquiry of drawings or technical specifications.

According to one embodiment of the present invention, the interaction module 200 also includes a plant information interacting unit 204, which is used for sending a fourth operation instruction to the simulation module 300 according to the real-time operation of the user, and the fourth operation instruction is used for drive the simulation module 300 to position a target plant structure model and call detailed information of the target plant structure model.

Correspondingly, referring to Fig. 4, the simulation module 300 includes a plant instruction processing unit 303, the plant instruction processing unit 303 includes a target plant positioning unit 3031 and a plant information calling unit 3032.

The target plant positioning unit 3031 is used for highlighting a target plant structure model the user positioned in the virtual sandboxie and/or scene roaming, or obtaining the plant structure code entered by the user in the virtual sandboxie search box, and highlighting the target plant structure model corresponding to the plant structure code.

The plant information calling unit 3032 is used for calling the detailed information of the target plant structure model and generating links to the corresponding design drawings of the target plant structure model. The detailed information includes at least one of a name of the plant structure, a name of the plant where located, floors, compartments, elevations, radiation areas and geometric dimensions, the design drawing comprises a template drawing, a reinforcement drawing and/or an anchor position drawing of the target plant structure, so as to meet the requirements of the nuclear power design, construction, operation and retired practitioners.

According to one embodiment of the present invention, the interaction module 200 also includes a device information interacting unit 205 for sending a fifth operation instruction to the simulation module 300 according to the real-time operation of the user, and the fifth operation instruction is used for driving the simulation module 300 to position a target nuclear power device model and call detailed information of the target nuclear power device model.

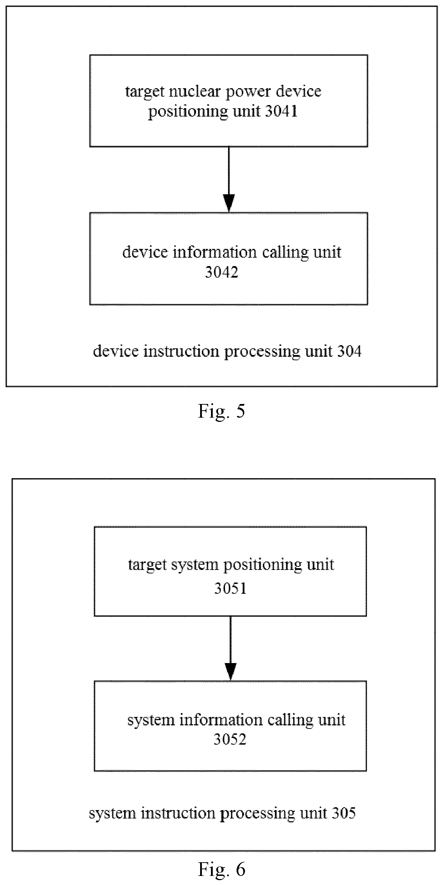

Correspondingly, referring to Fig. 5, the simulation module 300 includes a device instruction processing unit 304, the device instruction processing unit 304 comprises a target nuclear power device positioning unit 3041 and a device information calling unit 3042.

The target nuclear power device positioning unit 3041 is used for highlighting a target nuclear power device model which is positioned by the user in the virtual sandboxie, scene roaming and/or system information interaction; or obtaining a nuclear power device code entered by the user in the virtual sandboxie search box, highlighting the target nuclear power device model corresponding to the nuclear power device code.

The device information calling unit 3042 is used for calling the detailed information of the target nuclear power device model and generating a link to the corresponding design drawing of the target nuclear power device model, the detailed information comprises one or more of device names and abbreviations, space positions, ownership systems, device parameters, radiation data, device levels, purchasing and manufacturing information, and supplier information, the design drawings comprises installation drawings, device parts drawings, positioning drawings and/or device specifications of the target nuclear power equipment.

According to one embodiment of the present invention, the interaction module 200 also includes a system information interacting unit 206, which is used for sending a sixth operation instruction to the simulation module 300 according to the real-time operation of the user, and the sixth operation instruction is used for driving the simulation module 300 to position all models of the target system and call detailed information of the target system.

Correspondingly, referring to Fig. 6, the simulation module 300 includes a system instruction processing unit 305, the system instruction processing unit 305 includes a target system positioning unit 3051 and a system information calling unit 3052.

The target system positioning unit 3051 is used for obtaining a system code entered by the user in the virtual sandboxie search box, and highlighting all models of the target system corresponding to the system code; or obtaining a target system the user positioned in device information interaction, and highlighting all models of the target system.

The system information calling unit 3052 is used for calling detailed information of the target system and generating links to corresponding design drawings of the target system, the detailed information comprises one or more of system names and abbreviations, process parameters, system device lists, and radiation intensities, the design drawings comprise a system design guidance manual and/or a system flow chart.

The three-dimensional simulation display system for a nuclear power plant of the present invention has the ability to cover the distribution of the plant (including nuclear island plant, steam turbine plant and BOP plant), the three-dimensional model and information presentation of the system, structure and device in each plant. The three-dimensional simulation display system for a nuclear power plant of the present invention not only meets the needs of the general public and professionals for different interaction means, but also allows users to view detailed information about plant structure, systems and device, thereby breaking through the barriers between the three-dimensional models and various parameters, drawings and documents, displaying the three-dimensional radiation field of the nuclear power plant intuitively and professionally. The three-dimensional simulation display system for a nuclear power plant of the present invention can be used for on-site safety training of power plant staff, training regarding the processes of primary and secondary systems of a nuclear power plant, device training, human flow and material flow path planning during an overhaul and decommissioning, and on-site emergency drills. In addition, a solution is provided for common people to observe a nuclear power plant at close range, to know the working principle of the power plant and eliminate the fear of nuclear power.

One ordinary skilled in the art can clearly understand that, for the sake of convenience and brevity of description, the above-mentioned functional units, modules are only illustrative. In use, the functions can be distributed by different function units or modules according to actual needs. In other words, the internal structure of the device can be divided into different function units or modules, to perform all or part of the functions described above. The functional units and modules in the embodiment may be integrated in a processing unit. Each unit may physically exist separately from each other, or two or more units may be integrated in one unit. The integrated unit can be realized in the form of hardware or software function unit. In addition, the specific names of the functional units and modules are only for the convenience of distinguishing each other, and are not used to limit the scope of the present invention. The e working process of the unit and module in the system can be referred to the corresponding process in the method embodiment descrubed above, and will not be repeated here.

In the above embodiments, each one of the embodiments is described with particular emphasis. The parts of one embodiment that are not detailed or described can refer to the relevant descriptions of other embodiments.

Combined with the embodiments described in the present invention, one ordinary skilled in the art may be aware of the units and method steps of the embodiments can be implemented with electronic hardware, or a combination of computer software and electronic hardware. Whether the functions are performed as hardware or software depends on the specific application and design constraints of the technical solution. A professional technician may use different methods for each particular application to achieve the described function, but the implementation should not be considered beyond the scope of the present invention.

In the embodiments of the present invention, it should be understood that, the disclosed device/terminal device and method can be realized in other ways. For example, the device/terminal device embodiments described above are only illustrative. For example, the division of the module or unit is only a logical functional division, and can be implemented in a different way, for example, a number of units or components can be combined or integrated into another system, or some features can be ignored or not implemented. In addition, the coupling or direct coupling or communication connection among each other shown or discussed may be indirect coupling or communication connection through interface, device or unit electrically or mechanically.

The unit described as a separate part may or may not be physically separated, and the part shown as a unit may or may not be a physical unit, i.e., may be located in a place, or be distributed across multiple network units. Some or all of the units can be selected according to the actual needs to realize the purposes of the embodiment.

In addition, the functional units in each embodiment of the present invention can be integrated in a processing unit. Each unit can physically exist separately, or two or more units can be integrated in one unit. The integrated unit can be realized in the form of hardware or software function unit.

The above described embodiments are only preferred embodiments of the present invention, and are not intended to limit the scope of the present invention. Any modification, equivalent replacement and improvement within the spirit and principle of the present invention should be included in the protection scope of the present invention.

## Claims

1. A three-dimensional simulation display system for a nuclear power plant, **characterized in that** the three-dimensional simulation display system comprises a pre-editing module (100), an interaction module (200), a simulation module (300) and a display module (400),
wherein the pre-editing module (100) is used for setting initialization information, the initialization information comprises all models of the nuclear power plant, initial source item information of each model, and detailed information of the all plant device, system and plant structure;
the interaction module (200) is used for recording an operation instruction issued by a user and sending the operation instruction to the simulation module (300) for processing;
the simulation module (300) is used for receiving the operation instruction, calling target initialization information from the pre-editing module (100) according to the operation instruction, integrating the target initialization information and generating a corresponding feedback result, and sending the feedback result to the display module (400);
the display module (400) is used for presenting the feedback result to the user in form of a specific layout graphical interface.

2. The three-dimensional simulation display system for a nuclear power plant according to claim 1, **characterized in that** the pre-editing module (100) comprises a model processing unit, the model processing unit is used for modifying a preset model online or importing a target model file in a preset format, and automatically associating a corresponding script file after replacing an original model file with a target model file.

3. The three-dimensional simulation display system for a nuclear power plant according to claim 1, **characterized in that** the interaction module (200) comprises a virtual sandboxie interacting unit (201) and a radiation field interacting unit (202),
the virtual sandboxie interacting unit (201) is used for sending a first operation instruction to the simulation module (300) according to a real-time operation of a user, and the first operation instruction is used for calling a miniature sandboxie comprising all models, adjusting transparency of the models in the miniature sandboxie and an angle of horizontal rotation of the model around a central point, and automatically explaining, enlarging and reducing the miniature sandboxie; all models comprise a plant structure model of the nuclear power plant and a nuclear power device model;
the radiation field interacting unit (202) is used for sending a second operation instruction to the simulation module (300) according to the real-time operation of the user, the second operation instruction is used for calculating a three-dimensional radiation dose field of a target plant according to the initial source term information, and displaying the three-dimensional radiation field distribution cloud map in form of red-yellow-green gradient in the target plant.

4. The three-dimensional simulation display system for a nuclear power plant according to claim 3, **characterized in that** the simulation module (300) comprises a sandboxie instruction processing unit (301), the sandboxie instruction processing unit (301) is used for calling virtual sandboxie corresponding to different types of nuclear power units, and driving the display module (400) to display in a form of technology tree-like arrangement, in which the virtual sandboxie of different technical routes are arranged in parallel and the virtual sandboxie of the same technical route is arranged in a row from low to high.

5. The three-dimensional simulation display system for a nuclear power plant according to anyone of claims 1 to 4, **characterized in that** the interaction module (200) also comprises a scene roaming interacting unit (203), the scene roaming interacting unit (203) is used for sending a third operation instruction to the simulation module (300) according to a real-time operation of the user, and the third operation instruction is used for setting a roaming start, generating a roaming route according to the tour path roaming mode chosen by the user or the free roaming mode, and counting roaming information of the roaming route.

6. The three-dimensional simulation display system for a nuclear power plant according to claim 5, **characterized in that** the simulation module (300) also comprises a roaming instruction processing unit (302), the roaming instruction processing unit (302) comprises a roaming start acquiring unit (3021), a tour path roaming route generating unit (3022), a free roaming path generating unit (3023) and an adding unit (3024),
the roaming start acquiring unit (3021) is used for acquiring a virtual human position placed by the user during the virtual sandboxie interaction, and using the virtual human position as the roaming starting point; or acquiring a code entered by the user in the virtual sandboxie search box, and using the corresponding location of the code as the starting point for roaming;
the tour path roaming route generating unit (3022) is used for automatically planning and generating a shortest route, a least radiation absorbed dose route, an emergency evacuation route, or the human flow logistics route according to roaming purpose of the user;
the free roaming path generating unit (3023) is used for automatically generating a free roaming route according to a moving path of the virtual person in the virtual sandboxie, and counting roaming information comprising a route distance, a walking time and/or an intake dose;
the adding unit (3024) is used for adding the free roaming route selected by the user as a new emergency evacuation route or a human flow logistics route.

7. The three-dimensional simulation display system for a nuclear power plant according to claim 5, **characterized in that** the interaction module (200) also comprises a plant information interacting unit (204), a device information interacting unit (205) and/or a system information interacting unit (206), the plant information interacting unit (204) is used for sending a fourth operation instruction to the simulation module (300) according to the real-time operation of the user, and the fourth operation instruction is used for positioning a target plant structure model and calling detailed information of the target plant structure model;
the device information interacting unit (205) is used for sending a fifth operation instruction to the simulation module (300) according to the real-time operation of the user, and the fifth operation instruction is used for positioning a target nuclear power device model and calling detailed information of the target nuclear power device model;
the system information interacting unit (206) is used for sending a sixth operation instruction to the simulation module (300) according to the real-time operation of the user, and the sixth operation instruction is used for positioning all models of the target system and calling detailed information of the target system.

8. The three-dimensional simulation display system for a nuclear power plant according to claim 7, **characterized in that** the simulation module (300) also comprises a plant instruction processing unit (303), the plant instruction processing unit (303) comprises a target plant positioning unit (3031) and a plant information calling unit (3032),
the target plant positioning unit (3031) is used for highlighting a target plant structure model the user positioned in the virtual sandboxie and/or scene roaming, or obtaining the plant structure code entered by the user in the virtual sandboxie search box, and highlighting the target plant structure model corresponding to the plant structure code;
the plant information calling unit (3032) is used for calling the detailed information of the target plant structure model and generating links to the corresponding design drawings of the target plant structure model, the detailed information comprises at least one of a name of the plant structure, a name of the plant where located, floors, compartments, elevations, radiation areas and geometric dimensions, the design drawing comprises a template drawing, a reinforcement drawing and/or an anchor position drawing of the target plant structure.

9. The three-dimensional simulation display system for a nuclear power plant according to claim 7, **characterized in that** the simulation module (300) also comprises a device instruction processing unit (304), the device instruction processing unit (304) comprises a target nuclear power device positioning unit (3041) and a device information calling unit (3042),
the target nuclear power device positioning unit (3041) is used for highlighting a target nuclear power device model which is positioned by the user in the virtual sandboxie, scene roaming and/or system information interaction; or obtaining a nuclear power device code entered by the user in the virtual sandboxie search box, and highlighting the target nuclear power device model corresponding to the nuclear power device code;
the device information calling unit (3042) is used for calling the detailed information of the target nuclear power device model and generating links to the corresponding design drawing of the target nuclear power device model, the detailed information comprises one or more of device names and abbreviations, space positions, ownership systems, device parameters, radiation data, device levels, purchasing and manufacturing information, and supplier information, the design drawings comprises installation drawings, device parts drawings, positioning drawings and/or device specifications of the target nuclear power equipment.

10. The three-dimensional simulation display system for a nuclear power plant according to claim 7, **characterized in that** the simulation module (300) also comprises a system instruction processing unit (305), the system instruction processing unit (305) comprises a target system positioning unit (3051) and a system information calling unit (3052),
the target system positioning unit (3051) is used for obtaining a system code entered by the user in the virtual sandboxie search box, and highlighting all models of the target system corresponding to the system code; or obtaining a target system the user positioned in device information interaction, and highlighting all models of the target system;
the system information calling unit (3052) is used for calling detailed information of the target system and generating links to corresponding design drawings of the target system, the detailed information comprises one or more of system names and abbreviations, process parameters, system device lists, and radiation intensities, the design drawings comprise a system design guidance manual and/or a system flow chart.
